## Europäisches Patentamt

## European Patent Office

## Office européen des brevets

(11) Veröffentlichungsnummer: **0 234 244**

**A2**

(12) # EUROPÄISCHE PATENTANMELDUNG

(21) Anmeldenummer: **87100618.5**

(22) Anmeldetag: **19.01.87**

(51) Int. Cl.4: **H01L 21/265**

Die Bezeichnung der Erfindung wurde geändert (Richtlinien für die Prüfung im EPA, A-III, 7.3).

(30) Priorität: **24.01.86 DE 3602044**

(43) Veröffentlichungstag der Anmeldung:
**02.09.87 Patentblatt 87/36**

(84) Benannte Vertragsstaaten:
**DE FR GB IT NL**

(71) Anmelder: **Siemens Aktiengesellschaft Berlin und München**
**Wittelsbacherplatz 2**
**D-8000 München 2(DE)**

(72) Erfinder: **Binder, Harald, Dr.rer.nat.**
**Partnachplatz 7**
**D-8000 München 70(DE)**
Erfinder: **Föll, Helmut, Dr.rer.nat.**
**Albert-Schweitzerstrasse 42**
**D-8000 München 83(DE)**
Erfinder: **Holtschmidt, Walter**
**Hausenerstrasse 118**
**D-8011 Kirchheim(DE)**
Erfinder: **Kakoschke, Ronald, Dr.rer.nat.**
**Karlsbergstrasse 11**
**D-8000 München 71(DE)**

(54) **Verfahren um vertikale Seitenwände und Böden von Vertiefungen zu dotieren.**

(57) Die Erfindung betrifft ein Verfahren zum Herstellen einer definierten Dotierung in den vertikalen Seitenwänden (5) und Böden (4) von in Halbleitersubstrate (1) eingebrachte Vertiefungen (2) durch Ionenimplantation (3) und anschließendes Tempern. Dabei wird während der Ionenimplantation eine Relativbewegung zwischen Ionenstrahl (3) und Substrat (1, 2) ausgeführt, so daß ein Teil der Ionen (3) unter streifendem Einfallswinkel auf die Wandungen (4, 5) der Vertiefungen (2) auftrifft.

Durch das Verfahren wird eine sehr homogene Dotierung mit allen Dotierelementen erhalten; das Verfahren wird insbesondere verwendet bei der Herstellung von hochintegrierten Silizium-Schaltungen mit Speicherkondensatoren in Form von Grabenzellen.

## Verfahren zum Herstellen einer definierten Dotierung in den vertikalen Seitenwänden und Böden von in Halbleitersubstrate eingebrachten Vertiefungen.

Die Erfindung betrifft ein Verfahren zum Herstellen einer definierten Dotierung in den vertikalen Seitenwänden und in den Böden von in Halbleitersubstrate eingebrachten Vertiefungen, wie sie insbesondere für Speicherkondensatoren in Form von Grabenzellen in Siliziumsubstraten im sub$\mu$m-Bereich verwendet werden.

Die zunehmende Verkleinerung in integrierten Schaltungen benötigt neue Techniken für die Unterbringung der Bauelementstrukturen. Mit zunehmender Speicherkapazität von zum Beispiel dynamischen RAMs (= random excess memory = Speicherzelle mit wahlfreiem Zugriff) wird der für eine Speicherzelle zur Verfügung stehende Platz immer geringer. Die minimale Fläche des Speicherkondensators wird jedoch durch die Kapazität bestimmt, die notwendig ist, um genügend Ladungen für einen zuverlässigen Betrieb zu speichern.

Eine Möglichkeit, die Kondensatorfläche ohne zusätzlichen Platzbedarf zu vergrößern, besteht in der Verwendung sogenannter Grabenzellen, wie sie beispielsweise in einem Bericht von P. Morie, K. Minegishi und S. Nakajima im IEEE Electron Device Letters, Vol. EDL-4, No. 11, November 1983, auf den Seiten 411 bis 414 oder in einem Bericht von Minegishi, Nakajima, Miura, Harada und Toshitaka in den Proceedings of the IEEE International Electron Devices Meeting, Dezember 1983, auf den Seiten 319 bis 322 beschrieben sind. Ein Problem stellt dabei die Erzeugung eines definierten Dotierprofils an den vertikalen Seitenwänden des Grabens dar. Für das Beispiel der Grabenzelle sollte dieses Profil flach sein, um Leckströme zwischen eng benachbarten Grabenzellen zu verhindern.

Bei den bekannten Verfahren werden diese Profile durch Abscheidung von entsprechend dotierten Siliziumoxiden (zum Beispiel Phosphorsilikatglas) als Trägermedium im Graben und anschließende Ausdiffusion erzeugt. Anschließend wird das Trägermedium wieder abgelöst.

Wird eine Dotierung vom n-Typ gewünscht, so wird Arsen wegen des wesentlich kleineren Diffusionskoeffizienten im Vergleich zu Phosphor als Dotierelement bevorzugt. Bei der technischen Durchführung werden jedoch große Mengen hochgiftiger Arsenverbindungen benötigt, die das Verfahren aufgrund der notwendigen Sicherheitsmaßnahmen stark verteuern.

Aufgabe der Erfindung ist es, ein Dotierverfahren anzugeben, welches relativ einfach durchführbar ist und dennoch eine homogenere Dotierung als bisher und ohne schädliche Nebeneinflüsse oder zusätzliche Verfahrensschritte erlaubt.

Diese Aufgabe wird bei einem Verfahren der eingangs genannten Art dadurch gelöst, daß die Dotierung durch Ionenimplantation und anschließendes Tempern der Substrate erzeugt wird, wobei während der Ionenimplantation eine Relativbewegung zwischen Ionenstrahl und Substrat ausgeführt wird, so daß ein Teil der Ionen unter streifendem Einfallswinkel auf die Wandungen der Vertiefungen auftrifft. Dabei liegt es im Rahmen der Erfindung, daß sowohl ein Hochstrom-Implanter mit feststehendem Strahl und einer Strahldivergenz von 3 Grad verwendet wird, wobei der Durchmesser des Ionenstrahls auf einen Wert im Bereich von 5 cm eingestellt wird, als auch ein Mittelstrom-Implanter verwendet wird, dessen Ionenstrahl gleichmäßig über das Substrat gefahren wird.

Weitere Ausgestaltungen der Erfindung ergeben sich aus den Unteransprüchen.

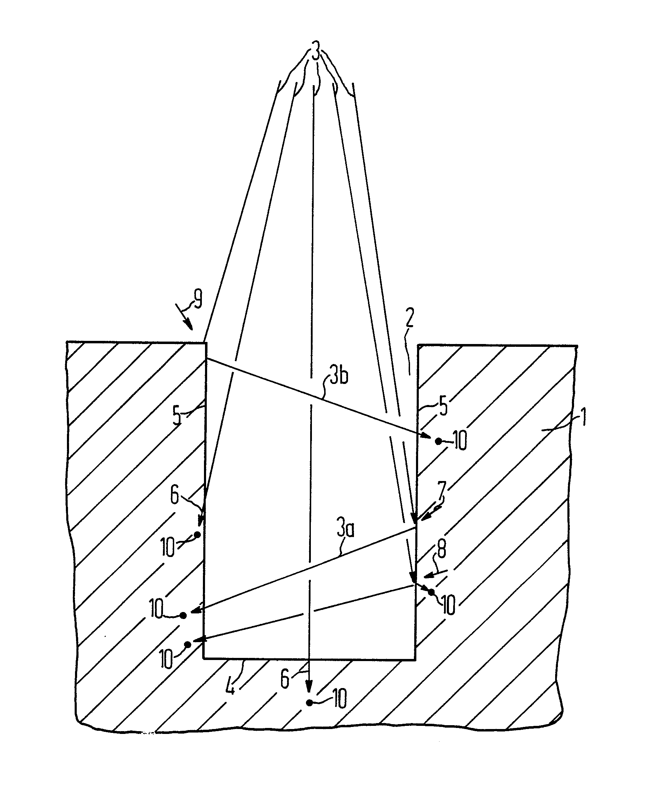

Die Erfindung läßt sich anhand der Figur, welche in schematischer Darstellung die Anordnung des mit einer Vertiefung 2 versehenen Substrates 1 zum Ionenstrahl 3 darstellt, folgendermaßen erklären:

Bedingt durch die Divergenz des Ionenstrahls und die endliche Ausdehnung der Ionenquelle - ("Emittanz") einerseits und der geometrischen Anordnung von Siliziumsubstratscheibe 1 mit Vertiefung 2 und Ionenstrahl 3 andererseits, trifft bei geeigneter Führung der Implantation ein beträchtlicher Teil der Ionen 3 unter streifendem Einfallswinkel auf die Innenwände der als Graben ausgebildeten Vertiefung 2. Verschiedene Prozesse sorgen nun dafür, daß die eingeschossenen Atome 10 des Dotierstoffes (3) nicht nur im Grabenboden 4 eingebaut werden, sondern auch in den Grabenwänden 5. Es finden folgende Prozesse statt:

1. Direktes Eindringen von Ionen 3, die an der Grabenwand 5 auftreffen (siehe Pfeile 6),

2. Rückstreuung von Ionen 3a an der Grabenwand 5, die dann an gegenüberliegenden Grabenwänden eindringen (siehe Pfeil 7),

3. Absputtern von nach obigen Mechanismen bereits vorhandenen Dotierstoffatomen 10 und Deponierung an anderer Stelle der Grabenwand - (siehe Pfeil 8),

4. Streuung von Ionen 3b an der Grabenwandkante (siehe Pfeil 9) bzw. Absputtern bereits vorhandener Atome von der Grabenwand.

Die Zahl und Tiefenverteilung der an einer gegebenen Stelle des Grabens (2) vorhandenen Dotierstoffatome 10 wird bestimmt durch

a) die Zahl der insgesamt implantierten Atome 10 (Dosis),

b) die bei der Implantation verwendeten Energien (Beschleunigungsspannung),

c) die Geometrie und Art eventuell vorhandener sogenannter Streuoxide,

d) die Winkeldivergenz des Ionenstrahls 3,

e) die Geometrie (das heißt Dimmension und exakte Form) der Gräben oder Löcher (2) und

f) die Geometrie der Implantation 3 (das heißt fester oder variabler Implantationswinkel).

Die endgültige Dotierung des Grabens liegt nach einem Temperprozeß vor. Dieser dient dazu, einerseits die eventuell entstandene Strahlenschädigung auszuheilen, andererseits durch thermische Diffusion die implantierten Dotierstoffatome in gewünschter Weise zu verteilen. Dieser Temperprozeß kann entweder durch herkömmliche Ofenprozesse oder aber durch sogenannte Schockausheilverfahren ("rapid annealing"), bei denen die Kristallscheibe kurzfristig auf über 1000°C aufgeheizt wird, durchgeführt werden.

Anhand von zwei Ausführungsbeispielen wird das Verfahren nach der Lehre der Erfindung noch näher erläutert.

Ausführungsbeispiel 1:

Die Implantation wird in einem Hochstrom-Implanter mit feststehendem Strahl (Durchmesser ungefähr 5 cm) und einer Strahldivergenz von 3 Grad durchgeführt. Ein Hochstrom-Implanter zeichnet sich dadurch aus, daß sich die Scheibe durch den Ionenstrahl bewegt.

Die zum Beispiel aus einkristallinem Silizium bestehende Substratscheibe 1 wird mechanisch durch den Strahl 3 bewegt, so daß überall im Mittel die gleiche Einstrahlgeometrie vorliegt. Die zu dotierenden Gräben 2 haben einen quadratischen Querschnitt von $1,0 \times 1,0$ $\mu m^2$ und sind 5 $\mu m$ tief. Als Dotierelement wird Arsen verwendet; die Beschleunigungsspannung beträgt 25 kV, die Dosis 1 $\times$ $10^{15}$ $cm^{-2}$. Ein Streuoxid wird nicht verwendet. Die anschließende Temperung erfolgt für 30 Minuten bei 900°C in Stickstoff-Atmosphäre. Die Grabenwand ist dann auf der gesamten Fläche dotiert.

Ausführungsbeispiel 2:

Es liegt auch im Rahmen der Erfindung, nicht die Grabenwände 4, 5 direkt zu implantieren, sondern eine zuvor auf die Grabenwände 4, 5 aufgebrachte Hilfsschicht, zum Beispiel aus polykristalli-nem Silizium (in der Figur nicht dargestellt). Bei der anschließenden Temperung erfolgt, bedingt durch die wesentlich schnellere Diffusion von Dotierstoffen im polykristallinen Silizium, zunächst ein Ausgleich eventuell bestehender Konzentrationsgradienten im polykristallinen Silizium, so daß dadurch beim Eintreiben der Dotierstoffe in die Siliziumgräben eine gleichförmigere Dotierung erreicht wird. Alternativ kann diese Hilfsschicht auch an Ort und Stelle belassen werden und für weitere Prozesse dann als dotiertes Silizium gelten.

Die Implantation wird in diesem Falle mit einem Mittel strom-Implanter durchgeführt, bei dem bekannterweise der Ionenstrahl 3 gleichmäßig über die Scheibe 1, 2 gefahren wird. Der Einfallswinkel variiert daher von Ort zu Ort. Das Dotierelement ist Phosphor; die Energie beträgt 80 kV, die Dosis 5 $\times$ $10^{14}$ $cm^{-2}$. Nach der Implantation werden die Gräben mit $SiO_2$ ausgekleidet, welches als Diffusionsbarriere dient. Durch eine anschließende Temperung (zum Beispiel 900°C, 1 Stunde) werden durch den hohen Diffusionskoeffizienten von Phosphor im polykristallinen Silizium Konzentrationsunterschiede entlang der Grabenwände ausgeglichen. Nach Ablösen des Oxids dient das polykristalline Silizium als Substrat für weitere Prozesse.

Folgende Möglichkeiten sind beim Verfahren nach der Lehre der Erfindung gegeben:

1. Die Implantation erfolgt in mehreren Stufen bei verschiedenen Energien, Dosen und/oder Orientierungen der Scheibe.

2. Die Winkeldivergenz des Ionenstrahls wird vorgegeben.

3. Das Substrat wird in Implantern mit gescanntem Strahl um seine Hauptachse rotiert; der Implantationswinkel wird frei gewählt.

4. Es wird vor der Implantation eine Streuschicht, insbesondere ein Oxid, mit Dicken im Bereich von 1 nm bis 100 nm aufgebracht.

5. Es wird vor der Implantation eine Hilfsschicht, in die implantiert wird, und in der das Dotierelement schneller diffundiert als in Silizium - (zum Beispiel polykristallines Silizium), aufgebracht.

6. Aus dieser Hilfsschicht wird die implantierte Dotierung in das darunterliegende Silizium durch Diffusion überführt; die Hilfsschicht wird anschließend wieder abgelöst. Das Eintreiben der Dotierung aus einer polykristallinen Silizium-Hilfsschicht erfolgt dadurch, daß die polykristalline Siliziumschicht oxidiert wird. Dadurch wird das in der polykristallinen Siliziumschicht enthaltene Arsen besonders effektiv in das Silizium überführt. Außerdem läßt sich die so erzeugte $SiO_2$-Schicht nach der Oxidation/Eintreibungsphase leichter ablösen.

7. Durch eine kurze Wärmebehandlung wird die Dotierung in der Hilfsschicht homogenisiert; die Hilfsschicht wird nicht wieder abgelöst, sondern als Substrat für nachfolgende Prozesse verwendet.

8. Die Löcher/Gräben können mit allen Elementen des Periodischen Systems dotiert werden.

9. Es können Löcher oder Gräben, außer in Silizium, auch in anderen Halbleitermaterialien, zum Beispiel in Germanium, Galliumarsenid, Indiumphosphid dotiert werden.

Bezugszeichenliste

1 = Substrat
2 = Vertiefung
3 = Ionenstrahl
4 = Grabenboden
5 = Grabenwandung
6, 7, 8, 9 = → Richtungspfeile
10 = Dotierstoffatome

**Ansprüche**

1. Verfahren zum Herstellen einer definierten Dotierung in den vertikalen Seitenwänden und in den Böden von in Halbleitersubstrate eingebrachten Vertiefungen, wie sie insbesondere für Speicherkondensatoren in Form von Grabenzellen in Siliziumsubstraten im sub$\mu$m-Bereich verwendet werden, **dadurch gekennzeichnet**, daß die Dotierung durch Ionenimplantation (3) und anschließendes Tempern der Substrate (1, 2) erzeugt wird, wobei während der Ionenimplantation (3) eine Relativbewegung zwischen Ionenstrahl (3) und Substrat (1, 2) ausgeführt wird, so daß ein Teil der Ionen (3) unter streifendem Einfallswinkel auf die Wandungen (4, 5) der Vertiefungen (2) auftrifft.

2. Verfahren nach Anspruch 1, **dadurch gekennzeichnet**, daß ein Hochstrom-Implanter mit feststehendem Strahl (3) und einer Strahlendivergenz von 3 Grad verwendet wird.

3. Verfahren nach Anspruch 2, **dadurch gekennzeichnet**, daß der Durchmesser des Ionenstrahls (3) auf einen Wert im Bereich von 5 cm eingestellt wird.

4. Verfahren nach Anspruch 1, **dadurch gekennzeichnet**, daß ein Mittelstrom-Implanter verwendet wird, dessen Ionenstrahl (3) gleichmäßig über das Substrat (1, 2) gefahren wird.

5. Verfahren nach Anspruch 4, **dadurch gekennzeichnet**, daß das Substrat (1, 2) um seine Hauptachse in Rotation versetzt wird.

6. Verfahren nach einem der Ansprüche 1 bis 5, **dadurch gekennzeichnet**, daß die Temperung vorzugsweise in Stickstoffatmosphäre bei 900°C in 30 bis 60 Minuten durchgeführt wird.

7. Verfahren nach einem der Ansprüche 1 bis 5, **dadurch gekennzeichnet**, daß eine Schocktemperung (rapid annealing) durchgeführt wird.

8. Verfahren nach einem der Ansprüche 1 bis 7, **dadurch gekennzeichnet**, daß die Implantation in mehreren Stufen bei verschiedenen Energien, Dosen und/oder Scheibenorientierungen durchgeführt wird.

9. Verfahren nach einem der Ansprüche 1 bis 8, **dadurch gekennzeichnet**, daß vor der Implantation eine aus $SiO_2$ bestehende, maximal 100 nm dicke Streuschicht aufgebracht wird.

10. Verfahren nach einem der Ansprüche 1 bis 9, **dadurch gekennzeichnet**, daß die Wände (4, 5) der Vertiefung (2) vor der Implantation (3) mit einer Hilfsschicht ausgekleidet werden, in der das Dotierstoffelement schneller diffundiert als im Substrat.

11. Verfahren nach Anspruch 10, **dadurch gekennzeichnet**, daß eine Hilfsschicht aus polykristallinem Silizium verwendet wird, wenn das Substrat aus einkristallinem Silizium besteht.

12. Verfahren nach einem der Ansprüche 1 bis 11, **dadurch gekennzeichnet**, daß vor der Temperung eine als Diffusionsbarriere dienende $SiO_2$-Schicht aufgebracht wird, die nach der Temperung wieder entfernt wird.

13. Verfahren nach Anspruch 11, **dadurch gekennzeichnet**, daß das Eintreiben der Dotierung aus der polykristallinen Siliziumschicht durch einen Oxidationsprozeß erfolgt.

14. Verfahren nach Anspruch 13, **dadurch gekennzeichnet**, daß die oxidierte Hilfsschicht durch Ätzen entfernt wird.

15. Verfahren nach Anspruch 10 und/oder 11, **dadurch gekennzeichnet**, daß zur Homogenisierung des Dotierstoffes in der Hilfsschicht eine maximal 30 Minuten dauernde Temperaturbehandlung bei 1000°C in Inertgasatmosphäre durchgeführt wird und die Hilfsschicht als Substrat für nachfolgende Prozesse verwendet wird.